# EUROPEAN PATENT APPLICATION

(11) **EP 1 081 247 A2**
(43) Date of publication of application: **07.03.2001**
(21) Application number: 00307109.9
(22) Date of filing: 18.08.2000
(51) Int. Cl.: C23C 14/32, H01J 37/32

(54) **Arc type ion plating apparatus**

(30) Priority: 18.08.1999 JP 23138599
(71) Applicant: Nissin Electric Co., Ltd., Kyoto-shi, Kyoto 615-0906 (JP)
(72) Inventor: Okazaki, Naoto, c/o Nissin Electric Co., Ltd, Kyoto-shi, Kyoto 615 (JP); Ohtani, Satoshi, c/o Nissin Electric Co., Ltd, Kyoto-shi, Kyoto 615 (JP)
(74) Representative: Carpenter, David

(57) **Abstract**

An arc type ion plating apparatus has a holder for holding substrates. The holder is provided in a vacuum vessel. One end portion of a bent transport tube is connected to this vacuum vessel so as to face the substrates on the holder. The transport tube has a rectangular or elliptical sectional shape. A plurality of arc evaporation sources are arranged in a longitudinal direction Y on the other end portion of the transport tube. The respective arc evaporation sources melt cathodes by vacuum arc discharge so as to generate plasma containing cathode material. Magnetic coils for forming a magnetic field bent along the transport tube are provided on the outer circumferential portion of the transport tube. The plasma generated by the arc evaporation sources is introduced by the magnetic field into the vicinities of the substrates in the vacuum vessel.

## Description

### BACKGROUND OF THE INVENTION

### 1. Field of the Invention

The present invention relates to an arc type ion plating apparatus in which a film superior in lubricity, hardness, decorativeness, etc. is formed on the surface of substrates of, e.g., tools, mechanical parts, molds, external cladding parts, and the like, by a so-called arc ion plating method using arc evaporation sources. Particularly, the present invention relates to an apparatus capable of forming a film high in smoothness in a large area with a good uniformity in film thickness.

### 2. Description of the Related Art

A so-called arc type ion plating method having the following particulars have been known. In the method, an arc evaporation source is used for melting a cathode by vacuum arc discharge so as to generate plasma containing cathode material and ions (means positive ions in this specification) in the plasma generated by this arc evaporation source are led onto a substrate by a negative bias voltage or the like so that a film is formed on the surface of the substrate. This method has features of a high film-forming speed, a high adhesion property of the film, and the like.

The reason why the film-forming speed is high is that the cathode is melted by use of vacuum arc discharge so that a large quantity of cathode material can be evaporated. The reason why the adhesion property of the film is high is that the ions in the plasma are led onto the substrate by an electric field generated by the negative bias voltage or the like so that the ions can collide with the substrate.

However, the cathode material evaporated from the cathode of the arc evaporation source contains not only fine particles suitable for film-forming but also bulky particles which are large lumps each having a diameter, for example, approximately in a range of from several µm to about tens of µm (which bulky particles are also called "droplets" or "macro-particles"). There is a problem that such bulky particles come flying to adhere to the substrate so that the smoothness in the film surface or the adhesion property of the film to the substrate is lowered.

As one means for solving this problem caused by bulky particles, JP-A-8-199346 discloses an arc type ion plating apparatus having an arc evaporation source with a gas blowing mechanism for blowing reactive gas to the vicinity of a cathode, which reactive gas reacts with material composing the cathode so as to produce a compound.

According to the arc type ion plating apparatus disclosed in this publication, the reactive gas reacts with the material composing the cathode so that a compound having a high melting point is formed on an evaporation surface of the cathode. Thus, a large number of cathode spots for arc discharge are formed so that an arc current is shared among the many cathode spots. As a result, it is possible to restrain bulky particles from flying about from the arc evaporation source. It is therefore possible to form a film superior in smoothness.

However, there are fields where it is necessary to further reduce bulky particles so as to form a film more excellent in smoothness, such as (1) the field of molds for forming lenses, (2) the field of protective films for electrodes inside cells or the like, which cannot be used it there is any pin hole. It has been difficult to apply the above-mentioned apparatus to such fields.

In addition, if the cathode of the arc evaporation source is of carbon, carbon does not form a high-melting compound differently from metal such as Ti, Ti-Al, Cr, or the like, even if reactive gas is blown. In addition, carbon evaporates while bursting. Accordingly, the effect of restraining bulky particles from flying about is so small that it has been difficult to form a carbon film superior in smoothness.

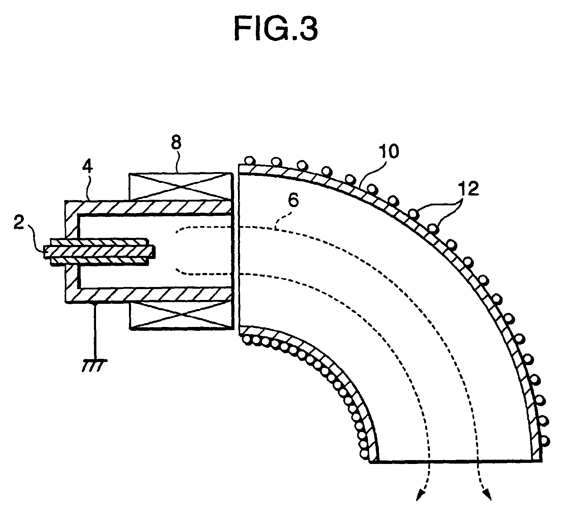

On the other hand, as another means for solving the problem caused by bulky particles, A. Anders et al Plasma Sources Sci. Technol. 4(1995)1-12 discloses a vacuum arc plasma transport apparatus as shown in Fig. 3.

In this apparatus, plasma 6 generated by vacuum arc discharge between a rod-like cathode 2 and a cylindrical anode 4 is focused by a focusing coil 8 and transported through a bent transport tube 10 having a circular sectional shape by a magnetic field generated by guide coils 12.

According to this apparatus, bulky particles contained in the plasma 6 generated near the cathode 2 are so large in mass that they cannot be bent sufficiently by the magnetic field generated by the guide coils 12. As a result, the bulky particles collide against the inner wall of the transport tube 10 and adhere thereto. Thus, the plasma 6 which contains few bulky particles can be led from an end portion of the transport tube 10. It is therefore considered that the apparatus can be applied to the above-mentioned fields where it is necessary to further reduce bulky particles so as to form a film higher in smoothness.

In addition, even if the cathode 2 is of carbon, bulky particles flying about from the cathode 2 can be removed in the transport tube 10. It is therefore considered that a carbon film high in smoothness can be formed.

In the apparatus in Fig. 3, however, only thin (small sectional area) plasma 6 can be generated and transported. Therefore, the film-forming area per apparatus is so small that it is difficult to apply the apparatus to film-forming in a large area. That is, the productivity is low. For the application to film-forming in a large area, for example, a lot of apparatus shown in Fig. 3 have to be installed so as to face a substrate. In such a case, the apparatus becomes too complicated and too heavy in weight to be put into practice use.

### SUMMARY OF THE INVENTION

It is an object of the present invention to provide an arc type ion plating apparatus in which a film high in smoothness can be formed in a large area with a good uniformity in film thickness.

According to the present invention, there is provided an arc type ion plating apparatus comprising: a vacuum vessel to be evacuated; a holder provided in the vacuum vessel for holding substrates; a transport tube which is a bent tube having a substantially rectangular shape or a substantially elliptical shape in section, one end portion of the transport tube being connected to the vacuum vessel so as to face the substrates held on the holder; a plurality of arc evaporation sources respectively having cathodes which are melted by vacuum arc discharge so as to generate plasma containing cathode material, the arc evaporation sources being disposed on the other end portion of the transport tube and arranged in a direction along long sides of the rectangular sectional shape or the elliptical shape of the transport tube; and magnetic coils provided on an outer circumferential portion of the transport tube for forming a magnetic field bent along the transport tube so that the plasma generated by the plurality of arc evaporation sources is introduced by the magnetic field into the vicinities of the substrates in the vacuum vessel.

According to the above-mentioned arc type ion plating apparatus, a plurality of arc evaporation sources are disposed on the end portion of the transport tube and arranged in a direction along the long sides of the rectangular sectional shape of the transport tube or along the major axis of the elliptical sectional shape of the transport tube (hereinafter, referred to as "longitudinal direction"). Thus, plasma containing the cathode material can be generated by the arc evaporation sources, so that plasma of a large area extending in the longitudinal direction can be generated.

This plasma is guided and transported through the transport tube by the magnetic field produced by the magnetic coils. Then, bulky particles flying about from the arc evaporation sources go straight if they are electrically neutral. Even if the bulky particles are ionized, their mass is so large that they are not bent sufficiently by the magnetic field produced by the magnetic coils. Thus, they collide with the inner wall of the transport tube and adhere thereto. As a result, plasma which contains few bulky particles can be led from the end portion of the transport tube and introduced into the vicinities of the substrates.

By such an operation, a film which is very high in smoothness and which contains few bulky particles can be formed in a large area with a good uniformity in film thickness by the large-area plasma.

### BRIEF DESCRIPTION OF THE DRAWINGS

In the accompanying drawings:
Fig. 1 is a perspective view showing an embodiment of an arc type ion plating apparatus according to the present invention;
Fig. 2 is a horizontally sectional view of the apparatus in Fig. 1; and
Fig. 3 is a sectional view showing an example of a conventional vacuum arc plasma transport apparatus.

### PREFERRED EMBODIMENTS OF THE INVENTION

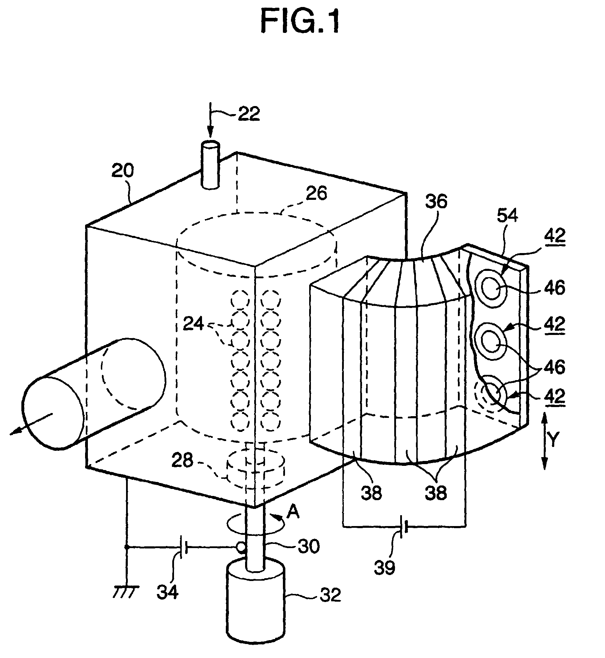

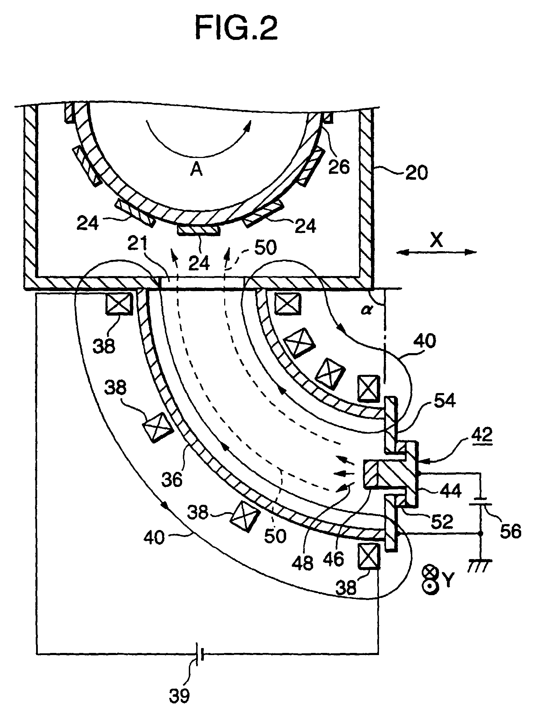

Fig. 1 is a perspective view showing an embodiment of an arc type ion plating apparatus according to the present invention. Fig. 2 is a horizontally sectional view of the apparatus in Fig. 1.

This arc type ion plating apparatus has a vacuum vessel 20 which is to be evacuated by a not-shown vacuum pump. A holder 26 for holding substrates 24 to be filmed is provided in the vacuum vessel 20. The vacuum vessel 20 and a transport tube 36, which is connected to the vacuum vessel 20 and which will be described later, are electrically connected to the ground in this embodiment.

The holder 26 which is cylindrical in this embodiment and a plurality of substrates 24 are attached to the side surface of the holder 26. The number, shape, and the like, of the substrates 24 are desirable. The holder 26 has a shape which is columnar or the like.

In this embodiment, the holder 26 is supported on a support shaft 30, and rotated, for example, in the arrow A direction by a driving portion 32. A bearing portion 28 having a vacuum seal function and an electrically insulating function is provided in the portion where the support shaft 30 penetrates the vacuum vessel 20, in this embodiment.

Gas 22 such as inert gas, reactive gas, or the like, is introduced into the vacuum vessel 20 in accordance with necessity. The inert gas is, for example, argon gas. The reactive gas is for producing a compound by reaction with cathode material 48 generated from the arc evaporation sources 42 which will be described later. The reactive gas is, for example, nitrogen gas.

In this embodiment, a negative bias voltage which is, for example, approximately in a range of from about minus tens of volts to about -1,000 volts is applied from a bias power supply 34 to the holder 26 and the substrates 24 held by the holder 26. However, even if a negative bias voltage is not applied to the substrates 24, that is, even if the bias power supply 34 is not provided and the substrates 24 are put in the ground potential level, plasma 50 (see Fig. 2) transported to the vicinities of the substrates 24 is put in a positive potential level more easily than the substrates 24. Accordingly, the potential difference between the plasma 50 and the substrates 24 can accelerate ions in the plasma 50 toward the substrates 24.

One end portion of the bent transport tube 36 is connected to an aperture portion 21 of the wall surface of the vacuum vessel 20 so as to face the substrates 24 on the holder 26. This transport tube 36 is also evacuated together with the vacuum vessel 20. The transport tube 36 has a substantially rectangular shape in section. The term "substantially rectangular shape" includes not only a rectangle literally but also a polygon (for example, octagon) close to the rectangle in which the corners (for example, four corners) of the rectangle are cut obliquely. In the case of such a polygon in section, large-area plasma 50 extending in a longitudinal direction Y can be generated and transported in the same manner as in the case of the rectangle.

Alternatively, the transport tube 36 may have a substantially elliptical shape in section. The term "substantially elliptical shape" includes not only an ellipse literally but also a polygon close to the ellipse. Also in the case of such a substantially elliptical shape in section, large-area plasma 50 extending in the longitudinal direction Y can be generated and transported in the same manner as in the case of the rectangle.

It is preferable that the angle α (see Fig. 2) with which the above-mentioned transport tube 36 is bent is set so that the substrates 24 on the holder 26 are not seen straightly from evaporation surfaces of cathodes 46 of the respective arc evaporation sources 42. In such a manner, bulky particles flying about from the cathodes 46 can be effectively restrained from reaching the substrates 24. More specifically, this angle α is set to be in a range of from about 45° to about 120°. It is preferable to set the angel α to 90° in practical view.

The other end portion of the transport tube 36 is covered with a rectangular terminal plate 54 in this embodiment. Three arc evaporation sources 42 are disposed on this terminal plate 54 in this embodiment so as to be arranged in a line in the direction Y (that is, longitudinal direction) which extends along the long sides in the rectangular section of the transport tube 36 (in other words, along the long sides of the rectangular shape of the terminal plate 54). That is, the arc evaporation sources 42 are disposed in three stages in the longitudinal direction Y.

In the case where the sectional shape of the transport tube 36 is substantially elliptical, the above-mentioned plural arc evaporation sources 42 may be arranged in the above-mentioned longitudinal direction Y, that is, along the major axis of the ellipse.

The plural arc evaporation sources 42 are not always arranged in a line so that their centers are on a line along the above-mentioned long sides or major axis of the transport tube 36. The arc evaporation sources 42 may be disposed so that their centers are shifted from one another to some extent. Even in such a case, it is possible to generate and transport the large-area plasma 50 extending in the longitudinal direction Y.

Each of the arc evaporation sources 42 has a cathode 46 attached to the metal cathode holder 44 in this embodiment. The cathode 46 is melted locally by vacuum arc discharge between the cathode 46 and the transport tube 36 or the terminal plate 54 which serves as an anode in this embodiment. Thus, the cathode material 48 is evaporated. Then, plasma is generated in the front vicinity of the cathode 46 by the arc discharge so that the cathode material 48 is ionized partially. That is, the plasma 50 containing the ionized cathode material 48 is generated in the front vicinities of the cathodes 46 of the arc evaporation sources 42 respectively.

At this time, among the cathodes 46 of the respective arc evaporation sources 42, the transport tube 36 and the terminal plate 54, an arc discharge voltage which is, for example, about tens of volts, is applied from an arc power supply 56 provided for each evaporation source 42, while the cathode 46 is set to be a negative pole side. The reference numeral 52 designates an insulator. Incidentally, each of the arc evaporation sources 42 usually has a trigger electrode for starting arc discharge, but it is not depicted here.

Each of the cathodes 46 of the arc evaporation source 42 is composed of desired material (for example, metal, an alloy, carbon, etc.) in accordance with the kind of a film to be formed. More specifically, the cathode 46 is composed of metal such as Ti, Cr, Mo, Ta, W, Al, Cu or the like, an alloy such as Ti-Al or the like, or graphite (carbon), by way of example. It is generally preferable that all the cathodes 46 of the respective arc evaporation sources 42 are composed of one and the same material.

Magnetic coils 38 are provided on the outer circumferential portion of the transport tube 36 to form a magnetic field bent along the transport tube 36. Thus, the plasma 50 generated by the arc evaporation sources 42 is introduced by this magnetic field to the vicinities of the substrates 24 on the holder 26 in the vacuum vessel 20. These magnetic coils 38 are excited by a DC exciting power supply 39. A part of magnetic flux 40 generated by the magnetic coils 38 is shown schematically in Fig. 2. The magnetic flux 40 runs substantially along the inner surface of the transport tube 36.

The magnetic coils 38 are composed of a plurality (four in the illustrated example) of toroidal coils in this embodiment. Instead, the coils may be composed of solenoidal coils wound along the outer circumferential portion of the transport tube 36.

Incidentally, members near the magnetic coils 38 are composed of non-magnetic material so as not to disturb the magnetic flux 40 generated by the magnetic coils 38.

According to this arc type ion plating apparatus, the three arc evaporation sources 42 are disposed in the longitudinal direction Y on an end portion of the transport tube 36. That is, the arc evaporation sources 42 are disposed in three stages. The plasma 50 containing the cathode material 48 can be generated by the arc evaporation sources 42. Thus, it is possible to generate the plasma 50 which is large in area so as to extend in the longitudinal direction Y.

This plasma 50 is guided and transported through the transport tube 36 having a substantially rectangular or elliptical section and by the magnetic field generated by the magnetic coils 38. Thus, the plasma 50 is introduced to the vicinities of the substrates 24 in the vacuum vessel 20. That is, electrons discharged from the cathodes 46 of the respective arc evaporation sources 42 are captured by the magnetic field generated by the magnetic coils 38 so as to move spirally. In addition, the cathode material 48 ionized by these electrons is transported through the bent transport tube 36 by an electric field generated by the captured electrons. By such an operation, the plasma 50 reaches the vicinities of the substrates 24 on the holder 26 in the vacuum vessel 20.

The ions (ionized cathode material 48) in the plasma 50 introduced into the vicinities of the substrates 24 are led onto the substrates 24 by a negative bias voltage or the like applied to the substrates 24. As a result, the ions collide with the substrates 24 so as to be deposited thereon. Thus, thin films are formed on the surfaces of the substrates 24. In that case, if reactive gas is introduced into the vacuum vessel 20 in advance, the cathode material reacts with the reactive gas so that thin compound films are formed on the surfaces of the substrates 24.

On the other hand, bulky particles flying about from the cathodes 46 of the respective arc evaporation sources 42 go straight if they are electrically neutral. Even if the bulky particles are ionized, their mass is so large that they are not bent sufficiently by the magnetic field generated by the magnetic coils 38, and they collide with the inner wall of the transport tube 36 and adhere thereto. That is, even if the ionized bulky particles are captured by the magnetic field generated by the magnetic coils 38 and move spirally, the bulky particles collide with the inner wall of the transport tube 36 and adhere thereto. This is because the radius (Larmor radius) of this spiral motion becomes larger in proportion to the mass and particularly in the case of the bulky particles, the Larmor radius is extremely large. Thus, the plasma 50 which contains few bulky particles can be led from the end portion of the transport tube 36 and introduced into the vicinities of the substrates 24.

By such an operation, films which are very high in smoothness and which contain few bulky particles can be formed on the respective substrates 24 on the holder 26.

In addition, the plasma 50 of a large area extending in the longitudinal direction Y can be generated by the plural arc evaporation sources 42 and transported by the transport tube 36 having a substantially rectangular or elliptical section. It is therefore possible to form a film in a large area and with a good uniformity in film thickness.

If the holder 26 for holding the substrates 24 is of a rotary type as in this embodiment, it is possible to form a film in a large area and with a well uniformity in film thickness. Instead of such a rotary-type holder, for example, a plate-like holder holding the substrates 24 may be provided to make a reciprocating linear motion in an X direction crossing the plasma 50 (see Fig. 2) in the vacuum vessel 20.

Incidentally, although there is an idea that a single arc evaporation source having a large-area rectangular cathode is provided in the end portion of the transport tube 36, it is preferable that a plurality of arc evaporation sources 42 are provided as in the present invention because the film-forming uniformity becomes high. That is, even if such a large-area cathode is used, an arc spot (cathode spot of arc discharge) is apt to stay at one place so that cathode material and plasma are generated with a bias. Particularly, in the case where the cathode is of carbon, the motion of the arc spot is so slow that the arc spot is apt to stay at one place for a long time (for example, about several minutes). Thus, such a bias increases. As a result, the uniformity of the plasma and hence the uniformity of the formed films are not good.

On the other hand, when the plural arc evaporation sources 42 are provided as in the present invention, a plurality (that is, a number not smaller than the number of the arc evaporation sources 42) of arc spots are inevitably present even in the case where the arc spots are apt to stay at one place in each of the cathodes 46. As a result, the cathode material 48 and the plasma 50 are generated from plural places dispersively, so that the uniformity of the plasma 50 and hence the uniformity of the formed films are improved.

Incidentally, each of the arc evaporation sources 42 may be provided with a gas blowing mechanism for blowing reactive gas to the vicinity of the cathode 46 of the arc evaporation source 42. The reactive gas reacts with the material composing the cathode 46. Thus, as described previously, bulky particles themselves can be restrained from flying about from the cathodes 46. It is therefore possible to form a film higher in smoothness.

### Example

An arc type ion plating apparatus configured as shown in Figs. 1 and 2 was used, and a plurality of disc-like substrates 24 composed of SCM415H were attached to the side surface of a cylindrical rotary holder 26 having an outer diameter of 450 mm. In addition, three arc evaporation sources 42 each having a cathode 46 composed of graphite (carbon) were arranged in three stages with a pitch of 20 cm in a longitudinal direction Y on an end portion of a transport tube 36 having a rectangular sectional shape. No gas blowing mechanism was provided in the arc evaporation sources 42 used in this example. The bending angle α of the transport tube 36 was set to be about 90°.

In the arc type ion plating apparatus having such a configuration, after the vacuum vessel 20 was evacuated to the extent of about 5 × 10⁻⁵ Torr, 100 sccm of argon gas was supplied as the gas 22 into the vacuum vessel 20, so that the pressure in the vacuum vessel 20 was kept to be about 5 mTorr. Then, in the state where a bias voltage of -50 V was applied from a bias power supply 34 to the holder 26 and the substrates 24, the three arc evaporation sources 42 were operated so that an arc current flowing into each arc evaporation source was kept to be 60 A.

As a result, carbon films could be formed on the surfaces of the respective substrates 24 held on the holder 26 at a film-forming speed of about 1 µm/hour. In addition, on the side surface of the cylindrical holder 26, a carbon film high in smoothness could be formed, with a good uniformity of film thickness, over a large area which extended over about 600 mm in its longitudinal length.

As has been described above, according to the present invention, a plurality of arc evaporation sources are disposed on an end portion of a transport tube and arranged in a direction along the long sides of the rectangular sectional shape or along the major axis of the elliptical sectional shape of the transport tube. Thus, plasma containing cathode material can be generated by the arc evaporation sources, so that plasma of a large area extending in the longitudinal direction can be generated. In addition, this plasma is guided and transported, through the bent transport tube having a rectangular sectional shape or an elliptical sectional shape, by a magnetic field produced by magnetic coils. As a result, plasma which contains few bulky particles can be led from the end portion of the transport tube and introduced into the vicinity of substrates.

As a result, a film which is very high in smoothness and which contains few bulky particles can be formed in a large area with a good uniformity in film thickness by the large-area plasma.

## Claims

1. An arc type ion plating apparatus comprising:
a vacuum vessel to be evacuated;
a holder provided in said vacuum vessel for holding substrates;
a transport tube which is a bent tube, one end portion of said transport tube being connected to said vacuum vessel so as to face said substrates held on said holder;
a plurality of arc evaporation sources respectively having cathodes which are melted by vacuum arc discharge so as to generate plasma containing cathode material, said arc evaporation sources being disposed on the other end portion of said transport tube and arranged in a direction along long sides of said rectangular sectional shape of said transport tube; and
magnetic coils provided on an outer circumferential portion of said transport tube for forming a magnetic field bent along said transport tube so that said plasma generated by said plurality of arc evaporation sources is introduced by said magnetic field into the vicinities of said substrates in said vacuum vessel.

2. The arc type ion plating apparatus according to claim 1, wherein said transport tube has a substantially rectangular shape in section.

3. The arc type ion plating apparatus according to claim 1, wherein said transport tube has a substantially elliptical shape in section.

4. The arc type ion plating apparatus according to claim 2, wherein said plurality of arc evaporation sources are arranged in a direction along a long sides of the rectangular sectional shape of said transport tube.

5. The arc type ion plating apparatus according to claim 3, wherein said plurality of arc evaporation sources are arranged along a major axis of the elliptical sectional shape of said transport tube.

6. The arc type ion plating apparatus according to claim 1, wherein an angle α with which said transport tube is bent is set so that the substrates on said holder are not seen straightly from evaporation surfaces of cathodes of said arc evaporation sources.

7. The arc type ion plating apparatus according to claim 7, wherein the angle α is set to be in a range of from about 45° to about 120°.

8. The arc type ion plating apparatus according to claim 1, wherein said coils are toroidal coils.

9. The arc type ion plating apparatus according to claim 1, further comprising a gas blowing mechanism for blowing reactive gas to a vicinity of the cathode of said arc evaporation source.
